# EUROPEAN PATENT APPLICATION

(11) **EP 1 936 648 A1**
(43) Date of publication of application: **25.06.2008**
(21) Application number: 06811619.3
(22) Date of filing: 11.10.2006
(51) Int. Cl.: H01H 25/04, G06F 3/02, H01H 89/00, H04M 1/23

(54) **OPERATION INPUT UNIT AND ELECTRONIC DEVICE USING SAME**

(30) Priority: 11.10.2005 JP 2005296591
(71) Applicant: OMRON Corporation, a corporation of Japan, Shiokoji-dori, Shimogyo-ku Kyoto-shi Kyoto 600-8530 (JP)
(72) Inventor: ARIHARA, Takeshi, Kyoto-shi, Kyoto 600-8530 (JP)
(74) Representative: Brykman, Georges
(86) International application number: PCT/JP2006/320312
(87) International publication number: WO 2007/043576

(57) **Abstract**

A thin operation input unit in which a high sensitivity characteristic of a magnetic field sensor is effectively utilized. The operation input unit comprises a base (10), a printed board (20) mounted with push button switches (21 to 25) and Hall elements (29a, 29b) on its upper surface and integrally laid on the base (10), an operation member (50) composed of a metal ring (51) integrated with press projections (59a to 59d) and supported on the base (10) vertically movably on the printed board (20), and an operation dial (70) having on its lower surface a ring magnet (65) where N and S poles are alternately arranged and rotatably attached to the upper surface of the operation member (50). When the operation dial (70) is rotated, the variation of the magnetic flux of the ring magnet (65) is detected by the Hall elements (29a, 29b) to detect the rotation direction. When the operation dial (70) is pressed, the push button switches (22 to 25) are operated by means of the press projections (59a to 59d) of the operation member (50).

## Description

### TECHNICAL FIELD

The present invention relates to an operation input unit that can be applied to a cellular phone or a portable music player.

### BACKGROUND ART

Conventionally, as an operation input unit used for a cellular phone or the like, there is one formed of a base, a printed board mounted with a plurality of push button switches and a magnetic field sensor on its upper face and integrally laid on the base, an operation panel placed on the printed board, and a disk-shaped operation dial having on its lower face a ring magnet where N and S poles are alternately arranged and rotatably attached onto the operation panel, for example. In the operation input unit, when the operation dial is rotated, variation of a magnetic flux of the ring magnet is detected by the magnetic field sensor to detect a direction of rotation. When the operation dial is pressed, the push button switches are operated (see Patent Document 1).
Patent Document 1: Japanese Patent Application Laid-open No. 2003-280799

### DISCLOSURE OF THE INVENTION

### PROBLEMS TO BE SOLVED BY THE INVENTION

However, if component parts are brought closer to each other in order to make the operation input unit thinner, an insulating characteristic is impaired and electrostatic short circuit is likely to occur.

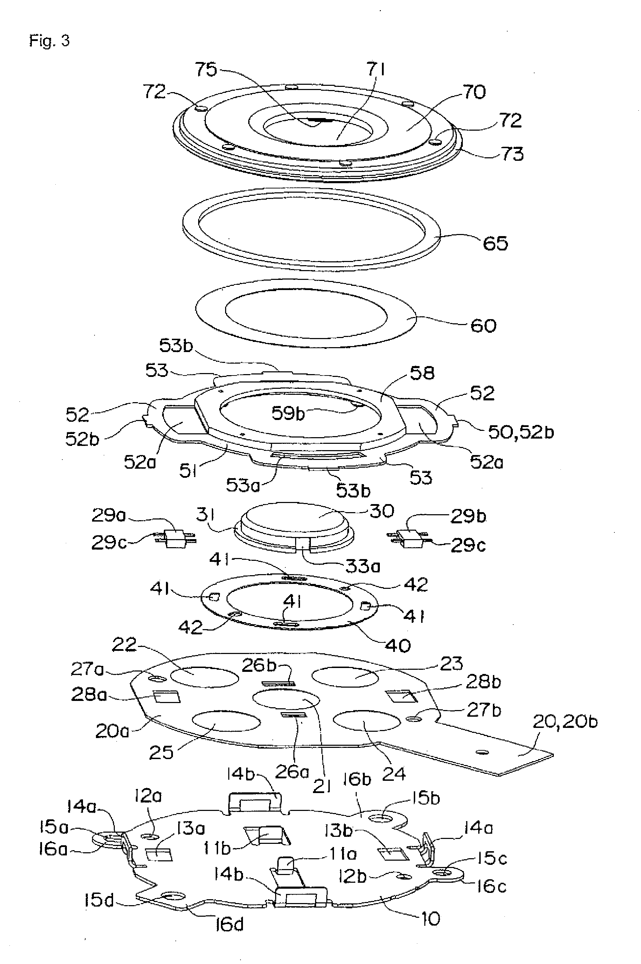

If an annular retaining portion 146 integrally retaining arc-shaped pieces 144, 144 shown in FIG. 3 of the prior art is made thinner, for example, in order to make the operation input unit thinner, a fatigue breakdown of the retaining portion 146 is likely to occur due to pressing-down force repeatedly applied to projections 150.

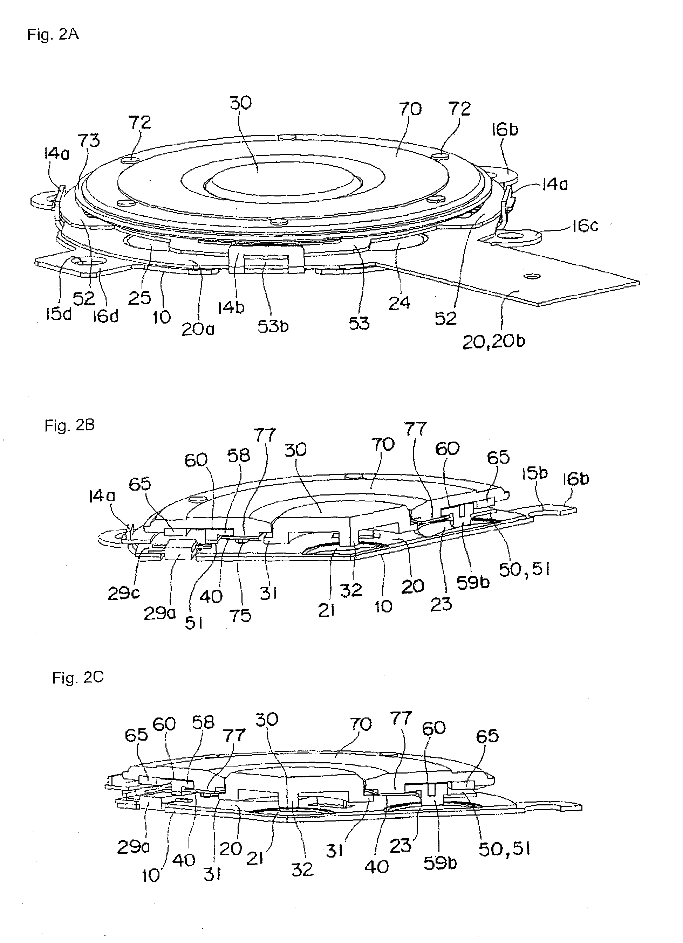

Moreover, in the operation input unit, as is clear from FIG. 2B that is a schematic illustration, a rotation detecting magnetic body 152 is extending diagonally above a Hall IC 136a mounted to the base 120. From a viewpoint of magnetic sensitivity, a layout in which the rotation detecting magnetic body 152 extends right above the Hall IC 136a is preferable. However, such a layout increases an overall height dimension of the operation input unit and the unit cannot be used for the cellular phone or the like that is desired to be thinner.

With the above problems in view, it is an object of the present invention to provide a thin operation input unit that can effectively utilize sensitivity characteristic of a magnetic field sensor.

### MEANS FOR SOLVING THE PROBLEMS

To solve the above problems, an operation input unit according to the present invention includes: a printed board mounted with a plurality of push button switches and a rotation detecting means on its upper face; an operation member formed of a metal thin plate portion and a resin material portion integrated with each other, having press projections, and supported vertically movably on the printed board; and a disk-shaped operation dial rotatably mounted onto an upper face of the operation member. The rotation detecting means detects a direction of rotation when the disk-shaped operation dial is rotated while the press projections of the operation member operate the push button switches when the disk-shaped operation dial is pressed.

### EFFECTS OF THE INVENTION

With the present invention, because the operation member is formed by integrating the metal thin plate portion and the resin material portion with each other, it is possible to obtain the operation input unit that can be made thinner than the prior-art unit, is excellent in rigidity, less liable to be damaged, excellent also in a sliding property, and has satisfactory rotating operability.

As an embodiment according to the present invention, the metal thin plate portion and the resin material portion may be integrally molded.
With the embodiment, by integrally molding the metal thin plate portion and the resin material portion, in addition to the above-described effects, it is possible to obtain the operation input unit having high productivity.

Another operation input unit according to the present invention includes: a printed board mounted with a plurality of push button switches and a magnetic field sensor on its upper face; an operation member supported vertically movably on the printed board; and a disk-shaped operation dial mounted on its lower face with a ring magnet where N and S poles are alternately arranged and rotatably mounted onto an upper face of the operation member. A lower side of the magnetic field sensor is sunk into a fitting hole formed in the printed board, the magnetic field sensor detects variation of magnetic flux of the ring magnet when the disk-shaped operation dial is rotated to detect a direction of rotation while the push button switches are operated through the operation member when the disk-shaped operation dial is pressed.

With the present invention, because the magnetic field sensor is mounted with its lower side sunk into the fitting hole in the printed board, a height dimension of the magnetic field sensor projecting from the upper face of the printed board becomes smaller and it is possible to obtain the thin operation input unit having a smaller height dimension.

As an embodiment according to the present invention, terminals projecting sideways from opposite side faces of the magnetic field sensor may be locked to an upper face opening edge portion of the fitting hole in the printed board to be electrically connected.
With the embodiment, because the magnetic field sensor can be mounted while sunk into the fitting hole in the printed board, positioning is easy and it is possible to obtain the operation input unit that can be easily assembled.

As another embodiment according to the present invention, the ring magnet may be disposed above the magnetic field sensor.
With the embodiment, because the ring magnet is disposed above the magnetic field sensor sunk into the fitting hole, it is possible to obtain the thin operation input unit in which a magnetic characteristic of the magnetic field sensor can be effectively utilized.

As another embodiment according to the present invention, front and back faces of the printed board mounted with the push button switches and the magnetic field sensor may be covered with an insulating resin sheet.
With the embodiment, because the push button switches and the magnetic field sensor are covered with the insulating resin sheet, electrostatic short circuit is less likely to occur even if the unit is made thinner and it is possible to obtain the operation input unit having a high insulation property.

In an electronic device according to the present invention, the above-described operation input unit is mounted with the disk-shaped operation dial exposed so that the dial can be operated from outside.

With the present invention, it is possible to obtain the thin electronic device in which the magnetic characteristic of the magnetic field sensor can be effectively utilized.

### BRIEF DESCRIPTION OF THE DRAWINGS

[FIG. 1] FIGS. 1A and 1B are a perspective view and a perspective view of an essential portion of a cellular phone mounted with an operation input unit according to the present invention.
[FIG. 2] FIGS. 2A, 2B and 2C are a perspective view and partially sectional views of the operation input unit shown in FIG. 1.
[FIG. 3] An exploded perspective view of the operation input unit shown in FIG. 2 and viewed from above.
[FIG. 4] An exploded perspective view of the operation input unit shown in FIG. 2 and viewed from below.
[FIG. 5] A partially enlarged sectional view of the operation input unit shown in FIG. 2.

### EXPLANATION OF REFERENCE NUMERALS

1: cellular phone
2: operation input unit
10: metal base
11a, 11b: positioning projection
12a, 12b: jig hole
13a, 13b: fitting hole
14a, 14b: elastic engagement receiving portion

20: printed board
20c: resin film cover
21 to 25: push button switch
26a, 26b: positioning hole
27a, 27b: jig hole
28a, 28b: fitting hole
29a, 29b: Hall element
29c: terminal

30: push button
31: retaining annular rib
32: press projection
33a, 33b: guide slit

40: fixing ring
41: positioning hole
42: swaging hole

50: operation member
51: metal ring
52: extending portion
52a: square hole
53: jutting portion
52b, 53b: elastic lug portion
58: mount portion
59a to 59d: press projection

60: sliding sheet
65: ring magnet

70: operation dial
71: operation hole
72: antislip projection
73: annular rib
74: annular groove
75: positioning projecting portion
76: swaging projection
77: lower face opening edge portion

### BEST MODE FOR CARRYING OUT THE INVENTION

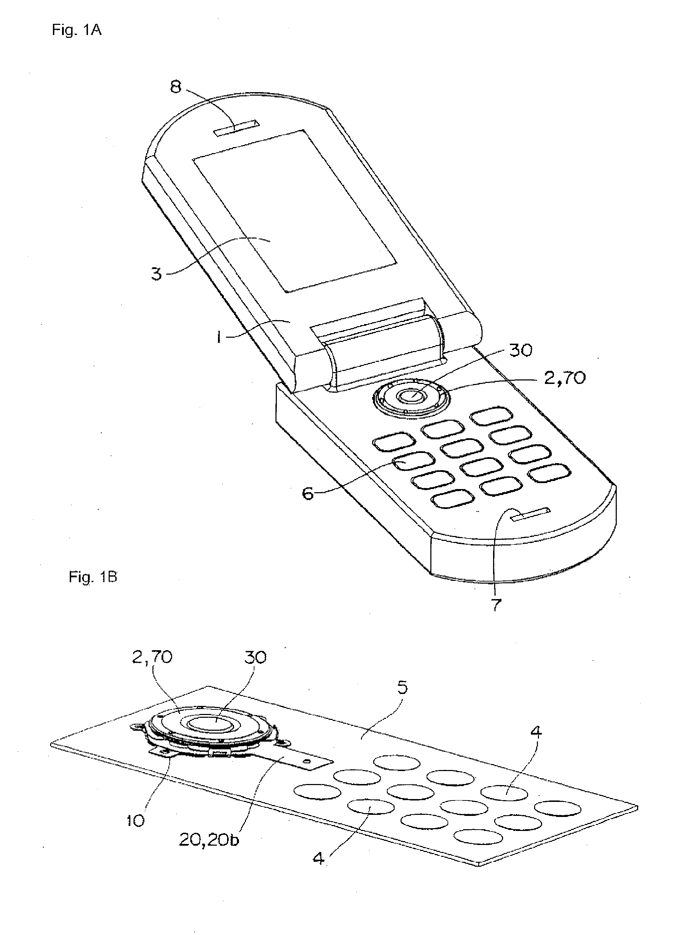

An embodiment of the operation input unit according to the present invention will be described according to the accompanying drawings from FIGS. 1 to 5.
With the operation input unit according to the embodiment, as shown in FIG. 1, it is possible to operate a scroll bar (not shown) on a monitor 3 to scroll by using the operation input unit 2 mounted to a printed board 5 in a cellular phone 1 and to issue a selection command by using a push button 30 and the like which will be described later. Reference numerals 4 designate push button switches mounted on the printed board 5, 6 designate numeric keys, 7 designates a microphone, and 8 designates a speaker.

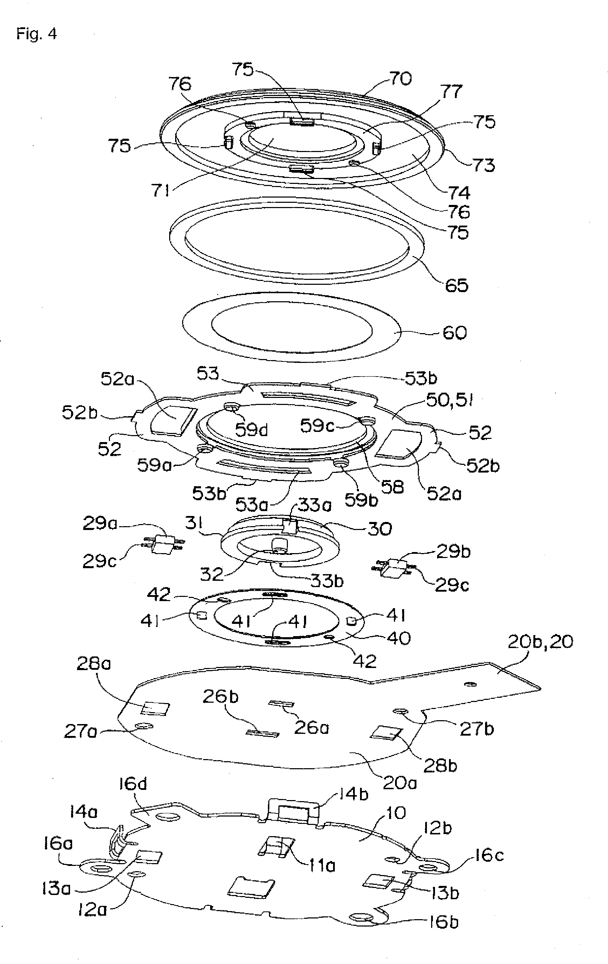

The operation input unit 2 is formed of a metal base 10, a printed board 20 made of a flexible resin film, the push button 30, a fixing ring 40, an operation member 50, a sliding sheet 60, a ring magnet 65, and an operation dial 70, as shown in FIGS. 3 and 4.

The metal base 10 is substantially circular in a plan view and a pair of positioning projections 11 a, 11 b is cut and bent up at a central portion as shown in FIGS. 3 and 4. The positioning projections 11 a, 11 b have different widths so as to prevent erroneous mounting. The metal base 10 is formed with jig holes 12a, 12b and fitting holes 13a, 13b in opposed positions close to an outer edge portion. Two pairs of elastic engagement receiving portions 14a, 14a, 14b, 14b are respectively cut and bent up at an outer peripheral edge portion of the metal base 10 to face each other with the positioning projections 11 a, 11 b disposed therebetween. From positions between the elastic engagement receiving portions 14a, 14b, tongue pieces 16a, 16b, 16c, and 16d respectively having mounting holes 15a, 15b, 15c, and 15d extend sideways.

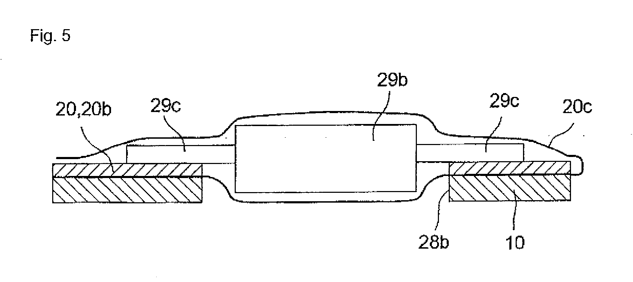

The printed board 20 made of the flexible resin film has substantially the same planar shape as the metal base 10 and is formed of a substantially circular board main body 20a having a back face applied with adhesive material and covered with release paper and a lead portion 20b extending from the board main body 20a. On the board main body 20a, a flat central push button switch 21 is disposed at a center and four flat push button switches 22 to 25 are disposed in opposed positions with the central push button switch 21 disposed therebetween. The board main body 20a is provided with positioning holes 26a, 26b in opposed positions with the central push button switch 21 disposed therebetween. Moreover, the board main body 20a is formed with jig holes 27a, 27b and fitting holes 28a, 28b in positions corresponding to the jig holes 12a, 12b and the fitting holes 13a, 13b in the metal base 10. Hall elements 29a, 29b from opposed side faces of which terminals 29c extend sideways are respectively fitted in and electrically connected to the fitting holes 28a, 28b in the printed board 20. The Hall elements 29a, 29b are respectively mounted while sunk into the fitting holes 28a, 28b and therefore the Hall elements 29a, 29b do not protrude high from an upper face of the printed board 20 (FIGS. 2B, 2C, and 5). This is advantageous because the operation input unit 2 thinner than the prior-art unit can be obtained.

Entire front and back faces except the positioning holes 26a, 26b and the jig holes 27a, 27b of the printed board 20 mounted with the push button switches 21 to 25 and the Hall elements 29a, 29b are covered with a resin film cover 20c (FIG. 5) to enhance an insulating property. However, the resin film cover 20c is not shown in FIGS. 1 to 4 for convenience of description.

The push button 30 has such an outer peripheral shape as to be inserted into an operation hole 71 of the operation dial 70 which will be described later and integrally formed at its outer peripheral lower edge portion with a retaining annular rib 31. The push button 30 is formed with a press projection 32 (FIG. 4) projecting from a center of its bottom face and formed with guide slits 33a, 33b (FIG. 4) to be engaged by sliding with the positioning projections 11 a, 11b of the metal base 10 at an outer peripheral face of the annular rib 31.

The fixing ring 40 is for rotatably retaining the operation dial 70 on the operation member 50 when positioning holes 41 of the fixing ring 40 are fitted with positioning projecting portions 75 (FIG. 4) provided to a lower face of the operation dial 70 which will be described later and swaging projections 76 of the operation dial 70 are fixed to swaging holes 42 of the fixing ring 40 by swaging.

The operation member 50 is formed by integrally molding a substantially annular resin mount portion 58 on a metal ring 51 having a substantially circular planar shape. The metal ring 51 is formed at its opposed outer peripheral edge portions with extending portions 52 having square holes 52a and jutting portions 53 having elongated holes 53a. From outer peripheral edge portions of the extending portions 52 and the jutting portions 53, elastic lug portions 52b, 53b project, respectively. In positions of a back face of the metal ring 51 corresponding to the push button switches 22 to 25, press projections 59a to 59d made of resin are formed to project from the mount portion 58. An inside diameter of the mount portion 58 is smaller than an outside diameter of the fixing ring 40. An inside diameter of the metal ring 51 is larger than the outside diameter of the fixing ring 40. As shown in FIG. 2B, an inner peripheral face of the mount portion 58 comes in contact with an outer peripheral face of a lower face opening edge portion 77 of the operation dial 70 which will be described later and slides when the operation dial 70 rotates. Because the mount portion 58 is made of resin, it has an excellent sliding property. The square holes 52a are through holes provided to facilitate passage of magnetic fluxes of the Hall elements 29a, 29b.

By forming the operation member 50 by integrating the metal portion and the resin portion with each other, the metal portion provides rigidity and the resin portion provides the sliding property, even if the operation member 50 is made thinner. In other words, the operation member 50 has both the rigidity and sliding property as a rotating body retaining part.
The metal ring 51 and mount portion 58 may be integrated with each other by integral molding, bonding, or fitting.

As shown in FIG. 4, outsides of the press projections 59a to 59d are positioned between the adjacent extending portions 52 and jutting portions 53 of the metal ring 51 and there are no jutting metal portions in the positions. This is for preventing a situation in which jutting portions come in contact and the press projections 59a to 59d cannot press the push button switches 22 to 25 when the operation member 50 tilts due to pressing down of the operation dial 70.
The press projections 59a to 59d may be made of resin and integrally molded with the mount portion 58 or may be made of different material from the mount portion 58, i.e., material other than resin. The press projections 59a to 59d may be provided to the mount portion 58 as described above or may be provided to the metal ring 51.

The sliding sheet 60 is in a shape of a concentric circle capable of covering an upper face of the mount portion 58 of the operation member 50 and is made of resin material having a predetermined friction coefficient.

In the ring magnet 65 includes N and S poles arranged alternately and is fitted and fixed into an annular groove 74 of the operation dial 70 which will be described later. Especially, according to the embodiment, the ring magnet 65 is designed not to come in contact with the operation member 50 when it is mounted into the annular groove 74 of the operation dial 70. Therefore, the operation dial 70 rotating integrally with the ring magnet 65 slides on the mount portion 58 of the operation member 50 with the sliding sheet 60 disposed therebetween. As a result, frictional resistance acting between them is small and there is an advantageous that a thin operation input unit that can be operated smoothly can be obtained.

The operation dial 70 is formed at its center with the operation hole 71 in which the push button 30 is to be fitted, provided at a periphery of its upper face with antislip projections 72 arranged radially at equal intervals, and provided at its outer peripheral edge portion with a retaining annular rib 73. The retaining annular rib 73 is used for preventing withdrawal from a case of an electronic device such as a cellular phone to which the unit is mounted. As shown in FIG. 4, the operation dial 70 is concentrically formed in its lower face with the annular groove 74 into which the ring magnet 65 is to be fitted and fixed. Furthermore, at the lower face opening edge portion 77 of the operation hole 71, the positioning projecting portions 75 for positioning the fixing ring 40 and the swaging projections 76 for fixing by swaging are concentrically formed to project. The operation dial 70 does not necessarily have to be in a circular shape but may be in a regular octagon shape as long as it is rotatable.

An assembly process of the above-described component parts will be described.
First, the jig holes 12a, 12b of the metal base 10 are respectively fitted over a pair of positioning pins of a jig (not shown) to thereby carry out positioning. On the other hand, the push button switches 22 to 25 and the Hall elements 29a, 29b are mounted in predetermined positions of the printed board 20. Then, the front and back faces of the printed board 20 except the positioning holes 26a, 26b and the jig holes 27a, 27b are covered with the resin film cover 20c. The jig holes 27a, 27b and the positioning holes 26a, 26b of the printed board 20 are respectively fitted over the positioning pins and the positioning projections 11a, 11b to thereby carry out positioning to stick and integrate the printed board 20 to and with the metal base 10.

On the other hand, the ring magnet 65 is fitted, bonded, and fixed to an outer peripheral base portion of a bottom face of the annular groove 74 of the operation dial 70 and the sliding sheet 60 is stuck to the rest of the bottom face and integrated. The bottom face of the annular groove 74 of the operation dial 70 and the mount portion 58 of the operation member 50 are fitted with each other to sandwich the sliding sheet 60 therebetween. Then, the positioning holes 41 of the fixing ring 40 are fitted over the positioning projecting portions 75 of the operation dial 70 to thereby carry out positioning and the swaging holes 42 of the fixing ring 40 are fitted over the swaging projections 76 and swaged. As a result, the operation member 50 and the sliding sheet 60 are sandwiched between the operation dial 70 and the fixing ring 40 and the operation dial 70 is rotatably supported on the operation member 50 with the sliding sheet 60 disposed therebetween.

Then, the push button 30 is positioned over the push button switch 21 on the printed board 20 and the guide slits 33a, 33b of the push button 30 are respectively engaged with the positioning projections 11a, 11b of the base 10 by sliding. The fitting hole 71 of the operation dial 70 is fitted over the push button 30 to prevent withdrawal and the elastic lug portions 52b, 53b of the operation member 50 are respectively engaged with the elastic engagement receiving portions 14a, 14b of the metal base 10 to thereby complete the assembly operation.

According to the embodiment, the operation member 50 is fixed to the base 10 in such a manner as not to rotate. By pressing down the operation dial 70, the press projections 59a to 59d of the operation member 50 respectively press down the push button switches 22 to 25 to take charge of a function of a pressing down operation. On the other hand, the operation dial 70 rotatably mounted to an upper face of the operation member 50 rotates to thereby take charge of a function of a rotating operation.

According to the embodiment, the elastic lug portions 52b, 53b of the operation member 50 are engaged with the elastic engagement receiving portions 14a, 14b of the base 10 and therefore horizontal wobbling can be prevented. Furthermore, the operation member 50 is biased upward by spring forces of the push button switches 22 to 25 and therefore vertical wobbling does not occur. Moreover, excessive rotation of the operation dial 70 due to an inertial force can be suppressed by friction produced against the sliding sheet 60 and therefore erroneous operation can be suppressed.

Next, how to operate the cellular phone 1 mounted with the operation input unit 2 having the above structure will be described.
If the ring magnet 65 rotates together with the operation dial 70 mounted into the cellular phone 1 by rotating the operation dial 70, the pair of Hall elements 29a, 29b respectively detects variation of the magnetic field and a direction and an amount of rotation are detected based on the detected variation.
Then, the detection results are reflected in a screen display of the monitor 3 as a movement of a scroll bar (not shown) via a control circuit (not shown). Then, by pressing the push button 30 when the scroll bar reaches a desired position, the press projection 32 operates the central push button switch 21 to output the selection command.
Furthermore, by pressing down the press projection 59b, for example, at the peripheral portion of the operation dial 70 as shown in FIG. 2C, a reverse spring of the push button switch 23 positioned directly below the press projection 59b may be reversed to bring the switch 23 into conduction.

Wobbling may be prevented by disposing an elastic pad between the upper face of the printed board 20 and a lower face of the operation member 50 to bias the operation member 50 upward.

### INDUSTRIAL APPLICABILITY

It is needless to say that the operation input unit according to the present invention may be applied not only to the cellular phone but also to other mobile devices and other electronic devices.

## Claims

1. An operation input unit comprising: a printed board mounted with a plurality of push button switches and a rotation detecting means on its upper face; an operation member formed of a metal thin plate portion and a resin material portion integrated with each other, having press projections, and supported vertically movably on the printed board; and a disk-shaped operation dial rotatably mounted onto an upper face of the operation member,
wherein the rotation detecting means detects a direction of rotation when the disk-shaped operation dial is rotated while the press projections of the operation member operate the push button switches when the disk-shaped operation dial is pressed.

2. An operation input unit according to claim 1, wherein the metal thin plate portion and the resin material portion are integrally molded.

3. An operation input unit comprising: a printed board mounted with a plurality of push button switches and a magnetic field sensor on its upper face; an operation member supported vertically movably on the printed board; and a disk-shaped operation dial mounted on its lower face with a ring magnet where N and S poles are alternately arranged and rotatably mounted onto an upper face of the operation member,
wherein a lower side of the magnetic field sensor is sunk into a fitting hole formed in the printed board, the magnetic field sensor detects variation of magnetic flux of the ring magnet when the disk-shaped operation dial is rotated to detect a direction of rotation while the push button switches are operated through the operation member when the disk-shaped operation dial is pressed.

4. An operation input unit according to claim 3, wherein terminals projecting sideways from opposite side faces of the magnetic field sensor are locked to an upper face opening edge portion of the fitting hole in the printed board to be electrically connected.

5. An operation input unit according to claim 3 or 4, wherein the ring magnet is disposed above the magnetic field sensor.

6. An operation input unit according to any one of claims 3 to 5, wherein front and back faces of the printed board mounted with the push button switches and the magnetic field sensor are covered with an insulating resin sheet.

7. An electronic device, wherein the operation input unit according to any one of claims 1 to 6 is mounted with the disk-shaped operation dial exposed so that the dial can be operated from outside.
